Europäisches Patentamt

European Patent Office

Office européen des brevets

(11) Veröffentlichungsnummer: **0 462 494 A1**

## (12) EUROPÄISCHE PATENTANMELDUNG

(21) Anmeldenummer: **91109551.1**

(22) Anmeldetag: **11.06.91**

(51) Int. Cl.5: **C30B** 11/00, C30B 29/06

(30) Priorität: **13.06.90 DE 4018967**

(43) Veröffentlichungstag der Anmeldung:
**27.12.91 Patentblatt 91/52**

(84) Benannte Vertragsstaaten:
**CH DE ES FR GB IT LI NL SE**

(71) Anmelder: **Wacker-Chemitronic Gesellschaft**
**für Elektronik-Grundstoffe mbH**
**Johannes-Hess-Strasse 24**
**W-8263 Burghausen(DE)**

(72) Erfinder: **Priewasser, Georg**
**Athaler Strasse 39**
**A-5122 Ach(AT)**
Erfinder: **Huber, Lothar**
**Mittergasse 12**
**W-8263 Burghausen(DE)**
Erfinder: **Spatzier, Gerhard**

**A-5142 Egglsberg 85(AT)**

(54) **Verfahren und Vorrichtung zum Giessen von Siliciumblöcken mit Kolumnarstruktur als Grundmaterial für Solarzellen.**

(57) Bei dem angegebenen Verfahren und mit Hilfe der angegebenen Vorrichtung wird aufgeschmolzenes Silicium kontinuierlich oder phasenweise erzeugt und zonenweise in eine Kokille eingefüllt, in der es zonenweise zum Erstarren gebracht wird. Die Temperaturverhältnisse in der Erstarrungszone werden dabei mit Hilfe einer beweglichen Heizzone gesteuert, mittels derer die Kristallisationsfront dem steigenden Füllstand in der Kokille nachgeführt wird, wobei dieser seinerseits über die Aufschmelzrate des Siliciums geregelt wird. Es lassen sich multikristalline Siliciumblöcke erhalten, bei denen wegen des ebenen Verlaufes der Kristallisationsfront die kolumnaren einkristallinen Bezirke innerhalb der Blöcke nahezu vertikal verlaufen, und welche ein ausgezeichnetes Solarzellengrundmaterial mit hohen Diffusionslängen und Lebensdauern der Minoritätsladungsträger darstellen, aus dem sich Solarzellen mit dementsprechend hohen Wirkungsgraden fertigen lassen.

Verfahren und Vorrichtung zum Gießen von Siliciumblöcken mit Kolumnarstruktur als Grundmaterial für Solarzellen.

Die Erfindung betrifft ein Verfahren zum Gießen von multikristallinen Siliciumblöcken als Grundmaterial für Solarzellen, bei dem vorgelegtes festes Silicium nach und nach durch Wärmezufuhr in einer Schmelzstation aufgeschmolzen, aus dieser kontinuierlich oder phasenweise freigegeben und einer Kokille zugeführt und dort zum Erstarren gebracht wird, sowie eine Vorrichtung zu seiner Durchführung.

Ein solches Verfahren ist aus der EP-A-55310 bekannt. Dabei wird, wie auch bei den anderen bisher bekannten Verfahren, bei denen schmelzflüssiges Silicium zu multikristallinen Blöcken (vgl. US-PS 4,382,838) vergossen wird, welche ggf. nach Abtrennen ungeeigneter Randbereiche und Zertrennen in kleinere Teilblöcke schließlich in Scheiben zersagt und nachfolgend zu Solarzellen weiterverarbeitet werden, jeweils die Kokille vollständig mit Siliciumschmelze gefüllt und dann erst, ggf. nach Überführung in eine eigene Kristallisierstation, der eigentliche Erstarrungsvorgang eingeleitet. Typisch für die erhaltenen Blöcke ist, daß meist nur im Zentrum eine annähernd senkrechte Ausrichtung der monokristallinen Bereiche zu beobachten ist, während zu den Randbereichen hin die Orientierung parabelartig sich an die Waagerechte annähert. Die Folge dieser Kristallisationscharakteristik sind einerseits vermehrt Kristalldefekte in den Kristalliten, andererseits ungünstige Segregationseffekte, die zu einer Anreicherung von Restverunreinigungen im Inneren der Blöcke führen. Beide Effekte verkürzen jedoch die Diffusionslängen der Minoritätsträger und verschlechtern somit letztendlich den Wirkungsgrad der erhaltenen Solarzellen.

Seit den Anfängen der Technologie des Gießens von Siliciumblöcken als Grundmaterial für Solarzellen (vgl. z.B. DE-A-25 08 803 bzw. die entsprechende US-PS 4,382,838) bestand daher das Bestreben, die Kristallisation des schmelzflüssigen Siliciums in der Kokille so zu gestalten, daß ein möglichst vertikales Wachstum der Kristallite vom Kokillenboden ausgehend eintritt und das von den Kokillenwänden ausgehende, sogenannte "Randwachstum" so weit als möglich zurückgedrängt wird. Bei einer solchen, den Wärmefluß über die Seitenwände der Kokille weitgehend reduzierenden Prozeßführung ergeben sich jedoch lange Kontaktzeiten zwischen Kokillenwandung und Schmelze, was zu einer Anreicherung von Verunreinigungen im Blockmaterial führt.

Ein anderer, bei einer Reihe der bekannten Gießprozesse verwirklichter Lösungsansatz zielt daher auf eine rasche Erstarrung der Schmelze im gesamten Randbereich, also insbesondere von den Seitenwänden der Kokille her, ab (vgl. z.B. DE-OS 34 27 465 bzw. die entsprechende US-PS 4,769,107). Dabei muß jedoch in jedem Fall ein verstärktes Randwachstum in Kauf genommen werden, selbst wenn durch zusätzliche Heizmaßnahmen versucht wird, dieses im Blockinneren weitgehend zu verlangsamen.

Die Aufgabe der Erfindung lag somit darin, ein Gießverfahren anzugeben, nach dem sich Siliciumblöcke erhalten lassen, die sich durch eine annähernd vertikale Orientierung der Kristallite auszeichnen und gleichzeitig nur ein geringes Randwachstum aufweisen.

Gelöst wird die Aufgabe durch ein verfahren, welches dadurch gekennzeichnet ist, daß in der Anfangsphase des Gießvorganges über den Kokillenquerschnitt im Bodenbereich eine zwischen erstarrtem und schmelzflüssigem Silicium verlaufende Kristallisationsfront erzeugt wird, welche mit Hilfe einer die Kokille im Bodenbereich umgebenden Heizzone stabilisiert wird, und daß im weiteren Verlauf des Gießvorganges mit der Zufuhr von schmelzflüssigem Silicium aus der Schmelzstation die Kristallisationsfront dem steigenden Füllstand nachgeführt wird, wobei sie durch eine Relativbewegung zwischen Kokille und Heizzone innerhalb letzterer gehalten wird, und die Schmelzenhöhe des die Kristallisationsfront überlagernden schmelzflüssigen Siliciums durch Abstimmung der durch Wärmezufuhr in die Schmelzstation gesteuerten zugeführten Schmelzenmenge und die Energiezufuhr in die Heizzone geregelt wird.

Eine zur Durchführung dieses Verfahrens geeignete Vorrichtung enthält eine die kontinuierliche oder taktweise Zufuhr von aufzuschmelzendem Silicium und die kontinuierliche Freigabe von geschmolzenem Silicium gestattende, beheizbare Schmelzstation, sowie daran angeschlossen mindestens eine mit einer zur Aufnahme des geschmolzenen Siliciums geeigneten Kokille beschickbare sowie Mittel zu deren Beheizung enthaltende Kristallisierstation, und ist gekennzeichnet durch eine die Kokille umgebende Heizzone, deren Höhe dem 0.1- bis 0.5-fachen des Außendurchmessers der Kokille entspricht, sowie Mittel, welche eine vertikale Relativbewegung zwischen Heizzone und Kokille gestatten.

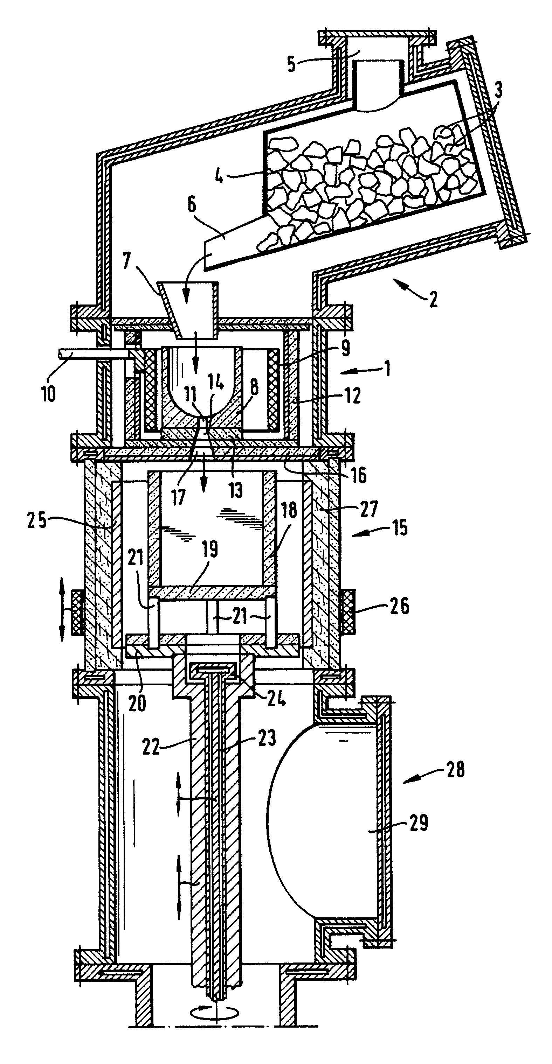

In der Figur ist eine mögliche Ausführungsform einer zur Durchführung des Verfahrens geeigneten Vorrichtung dargestellt. An Hand dieser Figur wird nachstehend zugleich auch das erfindungsgemäße Verfahren näher erläutert.

Schmelztiegel, in denen vorgelegtes festes Silicium nach und nach durch Wärmezufuhr aufgeschmolzen und in schmelzflüssiger Form kontinuierlich freigegeben wird, sind dem Fachmann bekannt und beispielsweise in der eingangs genannten EP-A-55 310 oder in der DE-A-35 31 610 bzw.

der entsprechenden US-PS 4,834,382 beschrieben. Analog gestaltete Schmelztiegel lassen sich auch bei der vorliegenden Erfindung für die Schmelzstation einsetzen. Eine vorteilhafte Ausführungsform ist in der Figur dargestellt. Dabei ist der eigentlichen Schmelzstation 1 eine Chargierstation 2 vorgeschaltet, in welcher das aufzuschmelzende Silicium 3, beispielsweise in stückiger, körniger oder Granulatform in einem Siliciumreservoir 4 vorgelegt ist. Die Zufuhr von weiterem Material kann beispielsweise über die Chargierschleuse 5 erfolgen. Nach Maßgabe der in der Schmelzstaion benötigten Materialmenge kann das Silicium dann über geeignete Fördereinrichtungen 6, z.B. eine Schüttelrinne oder ein Förderband, zur Austrittsöffnung, z.B. den Chargiertrichter 7 transportiert werden, durch den es schließlich die Chargierstation verläßt und in die eigentliche Schmelzstation 1 gelangt.

Hier wird das zuchargierte Silicium in dem Schmelztiegel 8 aufgefangen und nach und nach zum Aufschmelzen gebracht. Die erforderliche Heizenergie wird über die Schmelztiegelheizung 9 zugeführt, wobei die Energieeinspeisung z.B. über die Zuleitung 10 erfolgen kann, wenn z.B. eine Widerstandsheizung vorgesehen ist, mit der sich erfahrungsgemäß Temperaturprofile besonders fein einstellen lassen. Grundsätzlich kann die Beheizung des Schmelztiegels aber auch mittels induktiver oder Strahlungsheizung vorgenommen werden. Nach Maßgabe der zugeführten Heizleistung beginnen die Siliciumteile im Schmelztiegel allmählich aufzuschmelzen, wobei das geschmolzene Silicium zum Tiegelboden fließt und durch die Austrittsöffnung 11, in der Regel eine Bohrung mit etwa 0.5 bis 15 mm, vorzugsweise 1 bis 10 mm Durchmesser, kontinuierlich oder periodisch abfließen kann. Durch Verstärken bzw. Zurücknehmen der Heizleistung besteht dabei die Möglichkeit, die Aufschmelzrate des Siliciums und damit die Menge der abfließenden Schmelze oder das periodische Einsetzen bzw. Abklingen des Schmelzvorganges zu steuern.

Vorteilhaft befindet sich der Schmelztiegel im Inneren einer zusätzlichen Isolierkammer 12 aus thermisch isolierendem Material, wie etwa Graphit, Graphitfilz oder Siliciumnitrid, welche ihrerseits von den eigentlichen Außenwänden der Schmelzstation umgeben ist. Dadurch lassen sich Energieverluste über die in der Regel gekühlten Außenwände gering halten, wie auch Schwankungen in der zugeführten Heizleistung ausgleichen.

Bewährt haben sich bei dem Verfahren Schmelztiegel aus Quarz, da diese nach einer Anfahrphase in einem Temperaturbereich betrieben werden können, in dem der Quarz bereits plastisch ist und daher nur mehr ein geringes Bruchrisiko besteht. Grundsätzlich kommen aber auch andere, gegenüber geschmolzenem Silicium im wesentlichen entsprechend oder in stärkerem Maße inerte Materialien in Frage, wie z.B. Siliciumcarbid oder Siliciumnitrid.

Insbesondere bei der Verwendung von Quarztiegeln hat es sich bewährt, zur Stabilisierung des Tiegelbodens gegenüber Deformation eine zusätzliche Unterlage 13, beispielsweise aus Graphitmaterialien oder Siliciumnitrid, vorzusehen. Die Durchtrittsöffnung 14 für das abfließende Silicium wird dabei zweckmäßig konisch sich erweiternd gestaltet, um einen Wandkontakt des in der Regel nicht ideal senkrecht abfließenden Schmelzenstrahles zu vermeiden.

Obwohl es im Grunde möglich ist, die Schmelzstation 1 und die daran sich anschließende Kristallisierstation 15 direkt und ohne eine teilweise oder vollständige Abtrennung bewirkende Trenneinrichtungen ineinander übergehen zu lassen, wird gemäß einer bevorzugten Ausführungsform eine Zwischenplatte 16 vorgesehen, durch welche insbesondere der Gasaustausch zwischen Schmelz- und Kristallisierstation eingeschränkt oder im Grenzfall unterbunden wird. Dadurch läßt sich eine Verschleppung von Verunreinigungen wie z.B. Siliciummonoxid oder Siliciumcarbidpartikeln zwischen beiden Stationen über die Gasphase in einfacher Weise verhindern und somit die Reinheit des Produktes steigern.

Unterhalb der Austrittsöffnung 11 des Schmelztiegels sowie ggf. der Durchtrittsöffnung 14 der Unterlage ist in der Zwischenplatte eine vorteilhaft sich konisch erweiternde Durchtrittsöffnung 17 vorgesehen, deren lichte Weite günstig größer als die Streuung des durchfließenden Schmelzenstrahles ist, um dessen Kontakt mit der Wandung zu vermeiden und damit das Verunreinigungsrisiko zu senken.

Wird eine Zwischenplatte aus unter den Verfahrensbedingungen inertem Material mit hohem thermischem Isolationsvermögen, wie etwa Siliciumnitrid, vorgesehen, so läßt sich eine Beeinflussung der Temperaturverhältnisse in der Kristallisationsstation durch die Schmelztiegelheizung gering halten. Werden hingegen Zwischenplatten aus Material mit besserem Wärmeleitvermögen verwendet, das sich unter den Verfahrensbedingungen inert verhält, wie die bevorzugt eingesetzten Graphit- bzw. Graphitfasermaterialien, oder hochtemperaturfeste Metalle wie z.B. Molybdän oder Tantal, so läßt sich eine stärkere Wärmeeinstrahlung von der Oberseite der Kristallisationsstation aus erreichen, die dazu beiträgt, das wegen der Volumenausdehnung beim Erstarren gefürchtete Einfrieren der freien Oberfläche des in die Kristallisationsstation gelangten Siliciums zu verhindern. Somit kann durch die Auswahl des Plattenmaterials zu einer Optimierung der thermischen Verhältnisse in der Kristallisationsstation beigetragen werden.

Gegebenenfalls kann sogar eine zusätzliche Beheizungsmöglichkeit für die Zwischenplatte vorgesehen werden.

In der Kristallisationsstation 15 wird das in einem kontinuierlichen bzw. phasenweisen Strahl einfließende Silicium in einer Kokille 18 aufgefangen, deren Innenraum in etwa den Maßen des herzustellenden Blockes entspricht, wobei günstig zusätzlich eine Randzone von vorteilhaft etwa 0.5 bis 10 mm Dicke vorgesehen wird, in der sich ggf. auch Verunreinigungen anreichern können und die sich vom Gesamtblock nach dessen Entnahme abtrennen läßt, beispielsweise um die Blockmaße an eine vorgegebene Sollgröße anzupassen. Bei einer Standardgröße der (quadratischen) Solarzellen von 100·100 mm² haben sich Kokillenquerschnitte von 210·210 bis 430·430 mm² bewährt. Da es mit dem erfindungsgemäßen Verfahren wegen des günstigen Kristallisationsverhaltens möglich ist, gegenüber den bekannten Verfahren höhere Blöcke herzustellen, können Kokillen mit Höhen von 20 bis 50 cm eingesetzt werden. Grundsätzlich sind die Obergrenzen jedoch im wesentlichen maschinenbautechnisch vorgegeben, so daß auch größere Kokillenhöhen nicht ausgeschlossen sind.

Vorteilhaft besteht die Kokillenwandung aus hochtemperaturfestem Material wie z.B. Graphit, das zweckmäßig zumindest an den mit geschmolzenem Silicium in Kontakt kommenden Flächen mit Abdeckungen oder Beschichtungen aus siliciumresistentem keramischem Material versehen ist, wie etwa auf Quarz-, Siliciumnitrid- oder Zirkonoxidbasis. Derartige Stoffe kommen grundsätzlich auch als Materialien für die Kokillenwandungen als solche in Frage, ebenso wie z.B. auch beschichtetes Aluminiumoxid. Weiterhin lassen sich für die Abdeckung oder Beschichtung auch Schlackensysteme verwenden.

Zweckmäßig ist der Kokilleninnenraum würfel- bis quaderförmig gestaltet, wogegen die Außenwandung bevorzugt Zylinderform aufweist, obwohl grundsätzlich auch hier eine würfel- bis quaderförmige oder auch polyedrisch, wie etwa hexagonal oder oktogonal prismatische Gestaltung nicht ausgeschlossen ist.

Günstig ruht der Kokillenboden 19 nicht direkt auf der vorzugsweise dreh- und kühlbaren Trägerplatte 20, die z.B. aus hochtemperaturfesten inerten Materialien wie Graphit, Siliciumcarbid oder Siliciumnitrid gefertigt sein kann, sondern ist von dieser durch Distanzstücke, z.B. Distanzstäbe 21, beispielsweise aus Graphit, Graphitverbundstoffen, Siliciumnitrid oder Aluminiumoxid, getrennt, so daß ein der Einwirkung von Heizleistung zugänglicher Zwischenraum unterhalb der Kokille gebildet wird. Die Trägerplatte 20 ist mit einer drehbaren sowie heb- und senkbaren Welle 22 verbunden, die vorteilhaft einen über den Kühlkanal 23 mit einem Kühlmittel, in der Regel Wasser oder Wasserdampf, versorgten Kühlkopf 24 aufweist, der günstig höhenverfahrbar ist und mit der Trägerplatte oder vorteilhaft durch eine entsprechende Öffnung in dieser direkt mit dem Kokillenboden in Kontakt gebracht bzw. von diesem getrennt werden kann. Damit läßt sich eine doppelte Wirkung erzielen, nämlich indem einerseits die Kühlung des Kokillenbodens verstärkt wird, während andererseits auch die Kokille in die Gießposition in der Kristallisationsstation gebracht, während des Gießvorganges gegebenenfalls gedreht und abschließend in eine Transportposition außerhalb der Kristallisationsstation zurückgefahren werden kann. Für die Kühlung des Kokillenbodens kommen auch weitere Methoden in Frage, wie etwa Anblasen mit inerten Kühlgasen oder Kühlgasmischungen, beispielsweise Argon oder Helium.

Die zur Durchführung des erfindungsgemäßen Verfahrens erforderliche Heizzone kann gemäß einer bevorzugten Ausführungsform dadurch bereitgestellt werden, daß an der inneren, der seitlichen Kokillenaußenwandung zugewandten Wandseite der Kristallisationsstation eine Heizwand 25 vorgesehen ist, deren Höhe im wesentlichen der Strecke entspricht, entlang derer beim Gießvorgang die Heizzone relativ zur Kokille bewegt wird. Die Heizwand besteht aus induktiv beheizbarem Material, wie etwa Metallen wie Molybdän oder Tantal, oder bevorzugt Graphit. Die zur Erzeugung der Heizzone erforderliche Energie wird über eine die Kristallisationsstation außen umgebende, vertikal bewegliche Induktionsheizspule 26 eingespeist. Dabei hat sich eine dem 0.1- bis 0.5-fachen, insbesondere dem 0.2- bis 0.4-fachen des Außendurchmessers der Kokille entsprechende Höhe der Induktionsheizspule und damit letztlich auch der Heizzone als besonders günstig erwiesen.

Um die Wärmeverluste nach außen gering zu halten, ist die Außenwandung der Kristallisationsstation zweckmäßig mit einer Isolierschicht 27, beispielsweise aus gewirktem temperaturfestem Material wie etwa Graphitfilz umkleidet.

Eine andere Möglichkeit zur Erzeugung der Heizzone besteht darin, daß beispielsweise ein vertikal beweglicher, die Kokille umgebender widerstandsbeheizter Heizring oder Heizstreifen vorgesehen ist. Auch der Einsatz von Strahlungsheizern ist grundsätzlich nicht ausgeschlossen. In diesem Falle kann die eigentliche Rezipientenwandung im Bereich der Kristallisationsstation aus entsprechend temperaturfestem Metall, wie etwa Edelstahl, gefertigt sein. Bei Erzeugung der Heizzone mittels induktiver Methoden kommt hingegen in erster Linie nicht ankoppelndes Material in Frage, wobei sich insbesondere keramische Werkstoffe wie Quarz, Quarzglas oder Glaskeramiken bewährt haben.

Die Relativbewegung zwischen Kokille und Heizzone kann, wie bei der vorliegenden Ausführungsform, durch vertikales Hochfahren der Heizzone bewirkt werden. Nicht ausgeschlossen ist jedoch auch eine Absenkbewegung der Kokille bei feststehender Heizzone, oder auch eine kombinierte Bewegung von Kokille und Heizzone. Bevorzugt wird aber die Bewegung durch Translation der Heizzone ausgeführt, um die freie Länge des Schmelzenstrahles zwischen Schmelztiegel und Kokille möglichst gering zu halten.

Die Heizzone entspricht letztlich einem Temperaturfeld, innerhalb dessen vom Kokilleninhalt die Schmelz- bzw. Erstarrungstemperatur des Siliciums durchlaufen wird und welches stufenlos vertikal zumindest durch den zur Befüllung mit Silicium vorgesehenen Innenraum der Kokille geführt werden kann. In erster Näherung kann die wirksame Höhe der Heizzone und damit des Temperaturfeldes aus der Höhe der erzeugenden Heizeinrichtung, also z.B. der Induktionsheizspule, des Heizringes oder Heizstreifens abgeschätzt werden.

Vorteilhaft unterhalb der Kristallisationsstation angeordnet und beispielsweise über ein Flanschsystem mit dieser verbunden ist eine Verteilerstation 28. In einer solchen vertikal aufgebauten Anordnung läßt sich erfahrungsgemäß die Relativbewegung zwischen Heizzone und Kokille auf besonders einfache Weise realisieren. Grundsätzlich sind jedoch auch horizontal aufgebaute Anordnungen möglich, in der die Verteilerstation sich neben der Kristallisationsstation befindet, wobei auch Varianten in Frage kommen, bei denen anstelle einer Verteilerstation je eine Station zur Zufuhr und zur Entnahme der leeren bzw. befüllten Kokille vorgesehen sind.

Die gesamte Anordnung ist von einem gasdichten und die Einstellung einer Arbeitsatmosphäre kontrollierter Zusammensetzung gestattenden Rezipienten umgeben, wobei vorteilhaft die einzelnen Stationen durch geeignete Sperrelemente wie Schleusen oder Schieber zeitweise voneinander getrennt werden können. In der Regel ist der Rezipient aus Edelstahl gefertigt und doppelwandig gestaltet oder mit Kühlkanälen versehen, so daß er mit Hilfe eines durchströmenden Kühlmediums gekühlt werden kann. Wie bereits ausgeführt, empfehlen sich in Bereichen, in denen induktiv vermittels außerhalb des Rezipienten liegender Energiequellen, z.B. Induktionsheizspulen, beheizt wird, hingegen nicht ankoppelnde Werkstoffe wie etwa Quarz, Quarzglas oder ähnliches als Material für die Rezipientenwandung.

Die in der Figur dargestellte bevorzugte Ausführungsform kann, z.B. über eine Ein- und Ausschleusöffnung 29, mit einer leeren, vorbereiteten Kokille beschickt werden, die ggf. zusammen mit der Trägerplatte auf die in Be- und Entladestellung abgesenkte Welle z.B. mittels einer Transportgabel aufgestellt werden kann. Nach dem Einstellen einer geeigneten Arbeitsatmosphäre wie etwa einer Argon- oder Helium/Stickstoffatmosphäre und gegebenenfalls Ausheizen der Kokille kann das im allgemeinen vorgesehene Sperrelement, z.B. ein Vakuumschieber, zwischen Verteiler- und Kristallisationsstation geöffnet werden. Nun kann die Kokille mit Hilfe der Welle nach oben in die Kristallisationsstation gefahren werden, bis sie die Gießposition erreicht hat, in der die Kokillenöffnung möglichst nahe an die Durchtrittsöffnung in der Zwischenplatte herangeführt ist, aus welcher beim Gießprozeß das geschmolzene Silicium herausfließt.

Zweckmäßig wird in dieser Phase des Prozesses auch der Schmelztiegel auf eine Temperatur von ca. 1150 bis 1400°C, vorzugsweise 1250 bis 1350°C vorgeheizt, um den plastischen Bereich des Quarz zu erreichen, so daß bei Bedarf umgehend mit dem Zuchargieren von festem, vorteilhaft stückigem Silicium begonnen werden kann.

Wenn die Kokille die Gießposition erreicht hat oder während sie in diese Position gefahren wird, kann auch mit der Erzeugung der Heizzone begonnen werden. Die Induktionsheizspule befindet sich dabei zweckmäßig in einer Position, in der die erzeugte Heizleistung in der Endposition der Kokille im wesentlichen in den Zwischenraum zwischen Kokille und Trägerplatte einfließt, so daß vor allem der Kokillenboden beheizt wird. Die Temperatur kann z.B. mittels Thermoelementen oder Pyrometer überwacht werden; günstig wird der Kokillenboden auf eine Temperatur knapp oberhalb des Schmelzpunktes von Silicium erhitzt.

Zweckmäßig schon bei Erreichen einer Temperatur von ca. 1200-1300°C des Kokillenbodens kann der Schmelztiegel mit Silicium beschickt werden, wobei zugleich die auf ihn einwirkende Heizleistung hochgefahren und seine Temperatur auf einen Wert oberhalb des Siliciumschmelzpunktes (ca. 1420°C), vorteilhaft etwa 1450-1600°C gesteigert wird. Das zuchargierte Silicium beginnt dabei oberflächlich anzuschmelzen; das geschmolzene Material tropft nach unten, sammelt sich am Schmelztiegelboden und fließt durch die Austrittsöffnung in einem sich allmählich mit zunehmender Schmelzleistung verstärkenden und schließlich bei einer im wesentlichen konstanten Abflußrate stabilisierenden Strahl ab.

Das abgeflossene Silicium wird in der Kokille aufgefangen und bedeckt nach und nach als Schmelzsee vollständig den Kokillenboden. Nun wird nach Maßgabe des steigenden Füllstandes in der Kokille die Heizspule allmählich nach oben bewegt, so daß schließlich in der gebildeten Heizzone die Zone höchster Temperatur annähernd auf gleicher Höhe mit der Schmelzenoberfläche ist. Da nunmehr der Kokillenboden eine gegenüber dem Prozeßbeginn verringerte Heizleistung zugeführt erhält, beginnt er sich leicht abzukühlen, und die Kristallisation des Siliciums kann von ihm her einsetzen. Da die Heizleistung zu einem wesentlichen Anteil über die Kokillenseitenwände in den Kokilleninnenraum gelangt, kann durch Steigerung oder Verringerung der Spulenleistung eine annähernd horizontale, bisweilen sogar konvexe Kristallisationsfront zwischen dem schmelzflüssigen und dem erstarrten Silicium aufgebaut und stabilisiert werden. Als vorteilhaft hat sich dabei ein im wesentlichen ebener Verlauf der Kristallisationsfront erwiesen, wobei jedoch geringfügige Abweichungen in Richtung auf einen leicht konkaven oder konvexen Verlauf in der Regel zu keiner Verschlechterung der Blockqualität führen.

An diese Anfangsphase der Erzeugung und Stabilisierung der Kristallisationsfront schließt sich die Wachstumsphase an, in der einerseits kontinuierlich oder phasenweise weiteres schmelzflüssiges Silicium in die Kokille einfließt, und andererseits mit steigendem Füllstand die Kristallisationsfront sich vom Bodenbereich entfernt und, bei idealer Prozeßführung, im wesentlichen synchron mit der Schmelzenoberfläche in der Kokille nach oben wandert. Letztendlich bedeutet dies ein kontinuierliches zonenweises Wachstum des Blockes, bis der vorgesehene Füllstand in der Kokille erreicht ist, so daß die weitere Zufuhr von schmelzflüssigem Silicium unterbrochen werden kann, und die oberhalb des erstarrten Materials noch schmelzflüssig verbliebene Zone zur Kristallisation gebracht wird und ein vollständig erstarrter Block vorliegt.

Um einen derartigen Kristallisationsverlauf zu erreichen, wird durch die bereits beschriebene Relativbewegung zwischen Heizzone und Kokille die Kristallisationsfront innerhalb der Heizzone gehalten. Vorteilhaft wird dabei, bei ruhender oder langsam rotierender Kokille, die Heizzone von unten nach oben gefahren, wobei diese Bewegung zweckmäßig im wesentlichen synchron mit dem Anstieg des Schmelzenniveaus in der Kokille geführt wird. Wie bereits angedeutet kann bei idealer Prozeßführung im Grenzfall sogar erreicht werden, daß die Kristallisationsfront in gleicher Weise nach oben wandert.

Eine solche völlig oder im wesentlichen synchrone Kopplung des Fortlaufes von Kristallisationsfront und Schmelzenoberfläche im weiteren Verlauf des Gießvorganges ist jedoch nicht zwingend vorgeschrieben. Es wurde gefunden, daß sich auch bei Schwankungen der Schmelzenhöhe Blöcke mit ausgezeichneter Qualität erhalten lassen. Vorteilhaft wird die Schmelzenhöhe des die Kristallisationsfront überlagernden Siliciums im Bereich von 20 bis 50 mm gehalten. Die Steuerung kann über die Heizleistung der Heizzone, sowie die die Schmelzenzufuhr regelnde Heizleistung der Schmelzstation, und vorteilhaft durch Zusammenwirken dieser beiden Regelgrößen erfolgen. Als Faustregel kann angegeben werden, daß sich in den meisten Fällen bei einer Temperatur des schmelzflüssigen Siliciums an der freien Oberfläche im Bereich von etwa 1425 bis 1460°C die Kristallisationsfront in einem den genannten Schmelzenhöhen entsprechenden Abstand befindet. Bei dieser Abschätzung ist natürlich das Temperaturprofil innerhalb der Heizzone zu berücksichtigen.

In der Wachstumsphase wird die die Heizzone erzeugende Heizeinrichtung, bevorzugt eine Heizspule, dem steigenden Füllstand der Kokille in der Weise nachgeführt, daß die Kristallisationsfront innerhalb der Heizzone gehalten wird. Zweckmäßig liegt dabei die Zone höchster Temperatur oberhalb der Kristallisationsfront und innerhalb oder oberhalb des das erstarrte Silicium überlagernden Schmelzsees.

In besonders günstiger Weise kann die Höhe des Schmelzenniveaus in der Kokille, aus der sich letztlich die Sollposition der Heizzone ableitet, über die durch die zugeführte Siliciummenge bedingte Zunahme des Kokillengewichtes ermittelt und kontrolliert werden. Dies kann z.B. mit Hilfe von bekannten Gewichtssensoren geschehen, die beispielsweise an der Welle 22 angebracht sein können. Dem jeweils gemessenen Gewichtswert in Verbindung mit dem Kokillenquerschnitt läßt sich ausgehend vom Leergewicht der Kokille als Ausgangswert ein bestimmter Füllstand zuordnen, aus dem sich wiederum eine geeignete Position der Heizzone ableiten läßt. Vorteilhaft kann dies mit Hilfe einer Steuereinheit geschehen, in welche die jeweils aus dem Gewichtssignal sich ergebenden Steuergrößen für die Beheizung der Schmelzstation, der Heizzone sowie für die Relativbewegung zwischen Kokille und Heizzone einprogrammiert sind. Grundsätzlich kann die Prozeßsteuerung jedoch auch vollständig oder zumindest teilweise von Hand übernommen werden.

Eine besonders wirksame Feinsteuerung des Prozesses kann erreicht werden, wenn zusätzlich die Temperaturverhältnisse in der Kokille überwacht werden und zwar um so effektiver, je genauer aus den erfaßten Werten die jeweilige Lage der Kristallisationsfront festgelegt werden kann. Durch Verringerung oder Steigerung der Heizleistung in der Heizzone kann dann eine Beschleunigung oder Verlangsamung der Erstarrungsgeschwindigkeit erreicht werden, so daß die Kristallisationsfront exakter im gewünschten Sollbereich gehalten wird. Gleichzeitig lassen sich dadurch auch zu große, insbesondere zur Anreicherung von Verunreinigungen im Block führende Schwankungen der Erstarrungsgeschwindigkeit verhindern, da die Feinsteuerung frühzeitig auf Änderungen der thermischen Verhältnisse reagieren kann, die sich durch die Temperaturüberwachung auch besonders rasch erkennen lassen. Die Temperaturüberwachung kann beispielsweise über Pyrometer oder Thermoelemente vorgenommen werden, wobei grundsätzlich als Bezugssysteme sowohl der Kokilleninhalt als auch die Kokillenwandung in Frage kommen. Die resultierenden Temperaturwerte können sowohl bei Hand- als auch bei Rechnersteuerung des Prozesses als zusätzliche oder maßgebliche Steuergrößen herangezogen werden.

Obwohl aufgrund der zahlreichen zur Variation zur Verfügung stehenden Prozeßparameter auch große Variationsmöglichkeiten für die letztlich eingehaltene bzw. vorgegebene Erstarrungsgeschwindigkeit bestehen und Werte von bis zu 4 mm/min grundsätzlich möglich sind, haben sich Werte im Bereich von 0.1 bis 2.5 mm/min als günstig erwiesen. Es wurde gefunden, daß das in diesem Geschwindigkeitsbereich erstarrte Material ausgezeichnete Werte bei den Diffusionslängen der Minoritätsladungsträger zeigt, die für die Erzielung hoher Wirkungsgrade besonders wichtig sind.

Die Wachstumsphase kann in der Weise gestaltet werden, daß die Schmelzenzufuhr in die Kokille im wesentlichen kontinuierlich erfolgt. In der Praxis hat es sich zwar als einfacher erwiesen, die Schmelzenzufuhr phasenweise vorzunehmen, so daß phasenweise in der Kokille auch eine Zunahme der Schmelzenhöhe resultiert, und dann bei unterbrochener Schmelzenzufuhr die Kristallisationsfront bis zu einem vorgegebenen Grenzwert der Schmelzenhöhe, zweckmäßig etwa 15 bis 25 mm, nachzuführen, und danach wieder Schmelze einfließen zu lassen, bis auch hier der vorher festgelegte Grenzwert, in der Regel ca. 30 bis 50 mm erreicht ist. Erfahrungsgemäß wird jedoch um so besseres Material erhalten, je kürzer diese Phasen sind, so daß letztlich ein Prozeßverlauf am günstigsten ist, bei dem eine Schmelze nahezu konstanter Höhe gleichmäßig vor der Kristallisationsfront hergeschoben wird. Zur Überwachung und Steuerung eignen sich ausgezeichnet die Werte der Gewichtszunahme und die Kokillentemperatur.

Bei Erreichen der vorgesehenen Blockhöhe wird die Heizleistung in der Schmelzstation so weit zurückgenommen, daß kein weiteres schmelzflüssiges Silicium abfließt, und in der Kristallisationsstation wird der Erstarrungsvorgang zu Ende geführt. Danach kann, ggf. nach einer Temperphase von etwa 30 bis 500 min zum allmählichen Abbau thermischer Spannungen, die Welle mitsamt der Kokille in die Verteilerstation abgesenkt werden. Dort kann die gefüllte Kokille von der Welle genommen und beispielsweise in eine nachgeschaltete Kühlstation verbracht werden, wo die Kokille auf Entnahmetemperatur, in der Regel unterhalb 500° C, abgekühlt wird. Zwischenzeitlich kann auf die Welle eine vorbereitete neue Kokille aufgestellt werden, die dann zur Befüllung in die Kristallisationsstation hochgefahren wird.

Der schließlich aus der abgekühlten Kokille entnommene Block kann in der üblichen Weise zu Solarzellen weiterverarbeitet werden; die Kokille läßt sich ggf. nach einer Aufbereitung erneut in den Produktionszyklus zurückführen, sofern dies nicht durch zu starke Schäden unmöglich gemacht wird.

Das erfindungsgemäße Verfahren ermöglicht damit das Gießen von multikristallinen Siliciumblöcken durch zonenweises Erstarren unter Einhalten einer im wesentlichen ebenen Kristallisationsfront und optimaler Erstarrungsgeschwindigkeit. Das erhaltene Material zeigt innerhalb der Blöcke einen nahezu vertikalen Verlauf der kolumnaren einkristallinen Kristallbezirke und gleichzeitig einen besonders niedrigen Verunreinigungspegel für apparativ bedingte Verunreinigungen, wie in erster Linie Kohlenstoff oder Metalle. Gleichermaßen zeichnet es sich durch, verglichen mit den nach den bekannten Gießverfahren erhaltenen Solarzellengrundmaterialien, deutlich höhere Werte für die Diffusionslängen der Minoritätsladungsträger aus, die nahe an diejenigen heranreichen, die für einkristallines tiegelgezogenes Material typisch sind. Damit lassen sich aus diesem gegossenen Material Solarzellen mit bisher nicht oder mit großem Aufwand erzielbaren Wirkungsgraden fertigen.

Nachstehend wird die Erfindung an Hand eines Ausführungsbeispieles näher erläutert:

Beispiel:

In einer analog der Figur aufgebauten Anlage wurde das Siliciumreservoir der Chargierstation mit einer Menge von ca. 25 kg stückigem polykristallinem Silicium (mittlere Korngröße etwa 30 mm) beschickt. Über eine Schüttelrinne wurde nun eine Startcharge von ca. 2.5 kg dieses Materials in den Quarzschmelztiegel (Höhe ca. 20 cm, Durchmesser ca. 20 cm, Austrittsöffnung ca. 8 mm Durchmesser) der Schmelzstation chargiert, der mittels des umgebenden Widerstandsheizzylinders auf ca. 1350° C vorgeheizt war.

Gleichzeitig wurde eine Graphitkokille (Höhe ca. 25 cm, Außendurchmesser ca. 32 cm, Innenquerschnitt 21·21 cm$^2$) aus der evakuierten, Argongespülten Verteilerstation in die Kristallisationsstation hochgefahren, bis sie mit ihrer Öffnung knapp unterhalb der Zwischenplatte zu stehen kam. Bereits während dieses Vorganges wurde über die in Grundstellung am unteren Ende der Kristallisationsstation befindliche Induktionsheizspule (Durchmesser ca. 50 cm, Höhe ca. 10 cm, Material Kupfer) Heizenergie in die die Kokille umgebende Graphitheizwand eingekoppelt, so daß beim Durchfahren der damit erzeugten Heizzone die Kokillenwände gleichzeitig ausgeheizt wurden. Schließlich befand sich der durch Distanzstäbe aus Graphit zwischen Kokillenboden und Trägerplatte gebildete Hohlraum auf Höhe der Heizzone, deren Höhe in erster Näherung durch diejenige der sie erzeugenden Heizspule vorgegeben war.

Nun wurde sowohl die Spulen- als auch die Schmelzleistung gesteigert, bis das zunächst nur tropfenweise aus dem Schmelztiegel austretende geschmolzene Silicium in einem nahezu kontinuierlichen Strahl in die Kokille einzufließen begann. Sobald die Gewichtszunahme der Kokille anzeigte, daß eine Schmelzenhöhe von ca. 2 cm erreicht war, wurde in der Schmelzstation die Heizleistung etwas reduziert, so daß der Schmelzenstrahl sich etwas abschwächte.

Gleichzeitig wurde die Heizspule hochgefahren, bis die Zone maximaler Temperatur innerhalb der Heizzone auf der Höhe der Innenfläche des Kokillenbodens war. Die Heizleistung der Spule wurde nun so eingestellt, daß die Temperatur an der Schmelzenoberfläche im Bereich von ca. 1430 bis 1440°C lag. Danach wurde bei unveränderter Heizleistung die Spule allmählich weiter nach oben bewegt, bis sich die Zone maximaler Temperatur (deren Lage im wesentlichen der Querschnittsfläche durch die Spulenmitte entspricht) etwas oberhalb der Schmelzenoberfläche befand. Im Verlauf dieses Vorganges begann vom Kokillenboden her Silicium zu erstarren, bis sich eine im wesentlichen ebene Schicht erstarrten Siliciums ausgebildet hatte, die von Siliciumschmelze überlagert war. Damit war eine geeignete, im wesentlichen ebene Kristallisationsfront stabilisiert.

In der nun folgenden Wachstumsphase wurde einerseits die Heizleistung in der Schmelzstation so eingestellt, daß die darin vorgelegte Siliciummenge nach und nach aufschmolz und sich in einem phasenweisen Strahl in die Kokille ergoß, wobei periodisch Silicium aus dem Reservoir nachchargiert wurde. Die Gewichtszunahme in der Kokille entsprach im Mittel einem Schmelzenanstieg um etwa 0.2 mm/min; die Heizspule und damit die Heizzone wurde mit einer Geschwindigkeit von ebenfalls ca. 0.2 mm/min nach oben bewegt, woraus sich in etwa auch ein gleicher Wert für die Erstarrungsgeschwindigkeit des Siliciums ergab. Bei dem gesamten Vorgang konnte die Schmelzenhöhe des Schmelzsees, der in der Kokille vor der Kristallisationsfront hergeschoben wurde, durch die Abstimmung der Verfahrensparameter auf etwa 20 mm und im wesentlichen konstant gehalten werden.

Auf diese Weise wurde der Gießvorgang fortgeführt und stetig die Blockhöhe in der Kokille gesteigert. Ab einer Blockhöhe von ca. 15 cm wurde zur Unterstützung der Wärmeabfuhr durch Abstrahlung der wassergekühlte Kühlkopf der während des gesamten Gießprozesses gedrehten Welle (ca. 10 UPM) an den Kokillenboden herangeführt, ohne mit diesem direkt in Kontakt zu kommen.

Nachdem das Schmelzenniveau in der Kokille den vorgesehenen Wert für die Blockhöhe (ca. 23 cm) erreicht hatte, wurde in der Schmelzstation die Heizleistung zurückgefahren und der Schmelzstrahl unterbrochen. Die Bewegung der Induktionsheizspule wurde, bei gleichzeitiger allmählicher Rücknahme der Heizleistung, weitergeführt, bis die Schmelzenhöhe am oberen Ende des Blockes immer weiter abnahm und schließlich der Block vollständig durchkristallisiert war.

Nach Ablauf einer sich anschließenden, ca. 4-stündigen Temperphase, in der die Blocktemperatur auf etwa 500°C erniedrigt wurde, wurde die Welle, bei weiterer Drehung, abgesenkt und die Kokille aus der Kristallisationsstation in die Verteilerstation heruntergefahren. Gleichzeitig wurde die Heizspule in die Ausgangsstellung zurückbewegt.

Mit Hilfe einer Transportgabel wurde nun, nach Anhalten der Wellendrehung, die Kokille in eine Kühlstation verbracht, in der sich der Block auf Raumtemperatur abkühlen konnte. Auf die Welle wurde eine neue Trägerplatte mit Kokille aufgestellt, mit der in analoger Weise ein weiterer Gießvorgang durchgeführt werden konnte.

Aus der abgekühlten Kokille wurde der Siliciumblock entnommen und mittels einer Außentrennsäge in der Weise zersägt, daß schließlich vier Teilblöcke in den Sollmaßen, nämlich einem Querschnitt von 10·10 cm$^2$ und einer Blockhöhe von 20 cm zur Verfügung standen.

Alle Blöcke zeigten eine nahezu vertikale Ausrichtung der einkristallinen Bezirke in ihrer Kolumnarstruktur. Der spezifische Widerstand des Materials ergab sich zu 1.5 Ωcm und lag damit im Bereich der für tiegelgezogenes Material typischen Werte. Die mit der in dem Artikel von J.M.Borrego et al., "Non-destructive lifetime measurement in silicon wafers by microwave reflection", erschienen in Solid State Electronics, Vol. 30, No. 2, p. 195-203 (1987), beschriebenen Methode ermittelte Diffusionslänge der Minoritätsladungsträger betrug ca. 170 μm. Sie erreichte damit fast den für tiegelgezogenes einkristallines Material typischen Wert von 200 μm, und lag deutlich über dem für nach den üblichen Gießprozessen erhaltenem Material typischen Wert von ca. 119 μm. Auch die Lebensdauerwerte der Minoritätsladungsträger bewegten sich bei über 10 μsec und damit in einem Bereich, der für aus dem Produkt hergestellte Solarzellen ausgezeichnete Wirkungsgrade erwarten ließ.

Zur Überprüfung wurden aus dem erhaltenen multikristallinen Silicium nach einem üblichen Standardverfahren Solarzellen hergestellt und ihre Wirkungsgrade ermittelt. Diese lagen bei durchschnittlich ca. 15%. Hingegen betrugen die Wirkungsgrade von nach dem gleichen Standardverfahren hergestellten Solarzellen, bei denen durch ein herkömmliches Gießverfahren erhaltenes multikristallines Silicium als Grundmaterial eingesetzt wurde, durchschnittlich 13%.

## Patentansprüche

1. Verfahren zum Gießen von multikristallinen Siliciumblöcken als Grundmaterial für Solarzellen, bei dem vorgelegtes festes Silicium nach und nach durch Wärmezufuhr in einer Schmelzstation aufgeschmolzen, aus dieser kontinuierlich oder phasenweise freigegeben und einer Kokille zugeführt und dort zum Erstarren gebracht wird, dadurch gekennzeichnet, daß in der Anfangsphase des Gießvorganges über den Kokillenquerschnitt im Bodenbereich eine zwischen erstarrtem und schmelzflüssigem Silicium verlaufende Kristallisationsfront erzeugt wird, welche mit Hilfe einer die Kokille im Bodenbereich umgebenden Heizzone stabilisiert wird, und daß im weiteren Verlauf des Gießvorganges mit der Zufuhr von schmelzflüssigem Silicium aus der Schmelzstation die Kristallisationsfront dem steigenden Füllstand nachgeführt wird, wobei sie durch eine Relativbewegung zwischen Kokille und Heizzone innerhalb letzterer gehalten wird, und die Schmelzenhöhe des die Kristallisationsfront überlagernden schmelzflüssigen Siliciums durch Abstimmung der durch Wärmezufuhr in die Schmelzstation gesteuerten zugeführten Schmelzenmenge und die Energiezufuhr in die Heizzone geregelt wird.

2. Verfahren nach Anspruch 1, dadurch gekennzeichnet, daß die Kristallisationsfront auf einen im wesentlichen ebenen Verlauf stabilisiert wird.

3. Verfahren nach den Ansprüchen 1 oder 2, daß die Schmelzenhöhe des die Kristallisationsfront überlagernden schmelzflüssigen Siliciums im Bereich von 20 bis 50 mm gehalten wird.

4. Verfahren nach einem oder mehreren der Ansprüche 1 bis 3, dadurch gekennzeichnet, daß der Füllstand der Kokille durch ihre Gewichtszunahme kontrolliert wird.

5. Verfahren nach einem oder mehreren der Ansprüche 1 bis 4, dadurch gekennzeichnet, daß die Höhe der Heizzone dem 0.1- bis 0.5-fachen des Kokillendurchmessers entspricht.

6. Verfahren nach einem oder mehreren der Ansprüche 1 bis 5, dadurch gekennzeichnet, daß das Erstarren mit einer Geschwindigkeit von bis zu 4 mm/min vorgenommen wird.

7. Vorrichtung zur Durchführung des Verfahrens nach einem oder mehreren der Ansprüche 1 bis 6, enthaltend eine die kontinuierliche oder taktweise Zufuhr von aufzuschmelzendem Silicium und die kontinuierliche Freigabe von geschmolzenem Silicium gestattende, beheizbare Schmelzstation, sowie daran angeschlossen mindestens eine mit einer zur Aufnahme des geschmolzenen Siliciums geeigneten Kokille beschickbare sowie Mittel zu deren Beheizung enthaltende Kristallisierstation, gekennzeichnet durch eine die Kokille umgebende Heizzone, deren Höhe dem 0.1- bis 0.5-fachen des Außendurchmessers der Kokille entspricht, sowie Mittel, welche eine vertikale Relativbewegung zwischen Heizzone und Kokille gestatten.

8. Vorrichtung nach Anspruch 7, dadurch gekennzeichnet, daß die Heizzone mittels einer die Kokille zylinderförmig umgebenden Wandung aus induktiv beheizbarem Material sowie einer diese umgebenden vertikal beweglichen Induktionsheizspule, deren Höhe dem 0.1- bis 0.5-fachen des Außendurchmessers der Kokille entspricht, erzeugt wird.

9. Vorrichtung nach den Ansprüchen 7 oder 8, gekennzeichnet durch eine gegebenenfalls beheizbare, mit einer Durchtrittsöffnung für schmelzflüssiges Silicium versehene Zwischenplatte zwischen Schmelz- und Kristallisationsstation.

10. Vorrichtung nach einem oder mehreren der Ansprüche 7 bis 9, gekennzeichnet durch einen die durch die Aufnahme von schmelzflüssigem Silicium bedingte Gewichtszunahme der Kokille erfassenden Gewichtssensor sowie eine Steuereinheit, in der aus dem Gewichtssignal Steuergrößen für die Beheizung der Schmelzstation, der Heizzone sowie für die Relativbewegung zwischen Kokille und Heizzone abgeleitet werden.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 217 158 (WACKER-CHEMITRONIC GESELL-SCHAFT FÜR ELEKTRONIK-GRUNDSTOFFE mbH) <br> * Seite 6, Zeile 11 - Seite 7, Zeile 14; Ansprüche 1,9; Figur 1 <br> * & DE-A-3 531 610 (Kat. D) <br> – – – | 1,2,7 | C 30 B 11/00 <br> C 30 B 29/06 |
| A | EP-A-0 021 385 (HELIOTRONIC FORSCHUNGS- UND ENTWICKLUNGSGESELLSCHAFT FÜR SOLARZELLEN-GRUNDSTOFFE mbH) <br> – – – | | |
| A | EP-A-0 172 426 (HELIOTRONIC FORSCHUNGS- UND ENTWICKLUNGSGESELLSCHAFT FÜR SOLARZELLEN-GRUNDSTOFFE mbH) <br> & DE-A-3 427 465 <br> – – – | | |
| A,D | EP-A-0 055 310 (SEMIX INC.) <br> – – – – – | | |

| | | | RECHERCHIERTE SACHGEBIETE (Int. Cl.5) |
|---|---|---|---|
| | | | C 30 B |

Der vorliegende Recherchenbericht wurde für alle Patentansprüche erstellt

| Recherchenort | Abschlußdatum der Recherche | Prüfer |
|---|---|---|
| Den Haag | 03 Oktober 91 | COOK S.D. |